**Europäisches Patentamt**

**European Patent Office**

**Office européen des brevets**

(11) Veröffentlichungsnummer: **0 104 578**
**B1**

(12) **EUROPÄISCHE PATENTSCHRIFT**

(45) Veröffentlichungstag der Patentschrift:
**02.08.89**

(21) Anmeldenummer: **83109270.5**

(22) Anmeldetag: **19.09.83**

(51) Int. Cl.⁴: **H 03 M 1/66**

(54) **Digital-Analog-Wandler mit Potentialtrennung.**

(30) Priorität: **27.09.82 DE 3235741**

(43) Veröffentlichungstag der Anmeldung:
**04.04.84 Patentblatt 84/14**

(45) Bekanntmachung des Hinweises auf die Patenterteilung:
**02.08.89 Patentblatt 89/31**

(84) Benannte Vertragsstaaten:
**DE FR GB NL**

(56) Entgegenhaltungen:
**RADIO FERNSEHEN ELEKTRONIK, Band 31, Nr. 5, Mai 1982, Seiten 299,300, Ost-Berlin, DD; A. BOGATZ: "D-A-Wandlerbaustein"**
**PATENTS ABSTRACTS OF JAPAN, Band 5, Nr. 7 (E-41) 679 , 17. Januar 1981; & JP-A-55 137 721 (MITSUBISHI DENKI K.K.) 27-10-1980**

(73) Patentinhaber: **Siemens Aktiengesellschaft Berlin und München, Wittelsbacherplatz 2, D-8000 München 2 (DE)**

(72) Erfinder: **Ophoff, Paul Arthur, Ing. grad., Rheindammstrasse 22, D-6729 Wörth (DE)**

EP 0 104 578 B1

**Beschreibung**

Die Erfindung bezieht sich auf einen Digital-Analog-Wandler mit Potentialtrennung mit Hilfe von optoelektronischen Kopplungselementen.

Bei bekannten Ausführungen zur Umwandlung eines Digitalwerts von N bit in einen Analogwert ist eine der Bitzahl entsprechende Anzahl von Optokopplern notwendig, die parallel auf einen der üblichen Digital-Analog-Wandler, beispielsweise solche mit R/2R-Widerstandsnetzwerk, arbeiten.

Bei diesen bekannten Digital-Analog-Wandler treten Linearitätsfehler auf, eine Erhöhung der Auflösung hat überproportional hohe Kosten zur Folge.

Ein weiterer Digital-Analog-Wandler, der nicht nach der Methode der Widerstands-D-A-Umsetzung arbeitet, ist aus dem Dokument Radio Fernsehen Elektronik, Band 31, Nr. 5, Mai 1982, Seiten 299 - 300, Ost-Berlin, DDR; A. Bogatz: "D-A-Wandlerbaustein" bekannt. Gemäß der in diesem Dokument beschriebenen Schaltung wird ein Digitalwert Dn in einem Impulslängenmodulaor in die digitale Zwischengröße Tastverhältnis umgewandelt. Durch die so erzeugte Schaltspannung werden abwechselnd eine Referenzspannung (Zeit T ein) und die Spannung Null (Zeit T aus) auf eine mittelwertbildende Anordnung durchgeschaltet. Der dabei entstehende Mittelwert der Ausgangsspannung stellt ein Maß für den Digitalwert. Dn dar.

Bei diesem bekannten D-A-Wandler arbeitet der Impulsdauermodulator nach dem folgenden Prinzip:

Ein Generator erzeugt eine Rechteckspannung der Periode T. Ein Referenzzähler liefert nach einer seinem Zählumfang entsprechenden Zeit m.T einen Ausgangsimpuls. Durch diesen Impuls wird der Digitalwert Dn aus einem Zwischenspeicher in einen Vorwahlzähler geladen, und mit der Rückflanke des Impulses wird ein Flip-Flop getriggert. Der Vorwahlzähler liefert nun nach einer dem Digitalwert Dn entsprechenden Zeit n.T einen Ausgangsimpuls, wodurch das Flip-Flop rückgekippt wird. Der Vorgang wird erneut gestartet, wenn der Referenzzähler wieder einen Ausgangsimpuls liefert. Der Ausgang des Flip-Flops führt also während der Zeit n.T H-Pegel und während der Zeit (m - n).T L-Pegel. Das Tastverhältnis beträgt n/m und ist von der Grundtaktperiode unabhängig.

Wegen der sequentiellen Zusammenlegung der Referenzzahl und der den Digitalwert darstellenden Zahl ist dieser Wandler eher für Anwendungen, wo es nicht so sehr auf die Schnelligkeit der Umsetzung ankommt, geeignet.

Es besteht demgemäß die Aufgabe, einen Digital-Analog-Wandler einfachen Aufbaus zu schaffen, bei dem die Fehler der Digital-Analog-Wandler herkömmlicher Art weitgehend eliminiert sind.

Eine Lösung dieser Aufgabe wird erfindungsgemäß mit einem Digital-Analog-Wandler mit Potentialtrennung erreicht, der die Merkmale des Anspruchs 1 aufweist.

Für die Übertragung eines Digitalwerts von N bit ist nur noch ein einziger Optokoppler notwendig, als Mittelwertbildner kann vorzugsweise eine preisgünstige, aus RC-Netzwerken und einem Operationsverstärker in bekannter Weise aufgebaute, den Mittelwert einer periodischen Eingangsgröße bildende Schaltung verwendet werden.

Auch Digital-Analog-Wandler in Mehrkanal-Ausführung lassen sich gemäß der Lehre des Anspruchs 3 nach dem gleichen Prinzip in wenig aufwendiger Weise aufbauen.

Zur Erläuterung der Erfindung sind in den Figuren zwei Ausführungsbeispiele schematisch dargestellt und im folgenden beschrieben.

Es zeigen

Figur 1 eine Einkanal-Ausführung,

Figur 2 ein Schaltungsdetail (Mittelwertbildner) und

Figur 3 eine Mehrkanal-Ausführung.

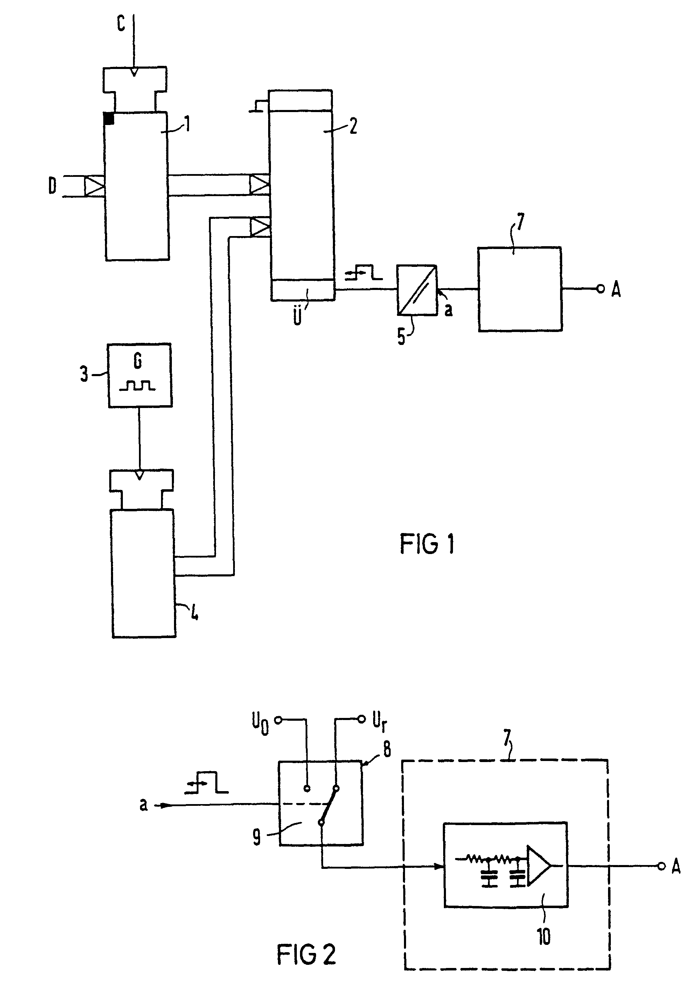

Figur 1: Über einen Datenkanal D wird ein Digitalwert von N bit (N = 8, 10 oder 12) einem Zwischenspeicher 1 mit N parallelen Speicherplätzen zugeführt. Die Eingangsfreigabe für den Zwischenspeicher 1 erfolgt - wie üblich - über den Triggereingang C.

Auf den Zwischenspeicher 1 folgt ein Volladdierer 2 mit Übertragsausgang Ü, an dessen Dateneingang neben dem Zwischenspeicher 1 ein von dem Taktgenerator 3 gesteuerter, frei laufender Zähler 4 mit N bit angeschlossen ist.

Am Übertragsausgang Ü des Volladdierers 2 tritt eine impulslängenmodulierte Impulsfolge auf, deren Puls/Pausen-Verhältnis genau dem in den Zwischenspeicher 1 eingelesenen Digitalwert entspricht.

Das periodische Ausgangssignal am Übertragsausgang Ü des Volladdierers 2 wird zur Potentialtrennung über einen Optokoppler 5 geführt, dessen Ausgangssignal a einem Mittelwertbildner 7 zugeführt ist, an dessen Ausgang ein dem digitalen Eingangswert entsprechendes analoges Ausgangssignal A ansteht.

In Figur 2 ist eine schaltungsmäßige Ausbildung des Mittelwertbildners 7 mit einem vorgeschalteten Rechteck-Impulsformer 8 dargestellt.

Der Impulsformer 8 besteht hier aus einem von dem Ausgangssignal a des Optokopplers 5 (Figur 1) impulsgesteuerten elektronischen Umschalter 9, an dessen einem Eingang eine Referenzspannung $U_r$ und an dessen anderem Eingang die Spannung $U_0$ liegt.

Als Mittelwertbildner 7 wird vorzugsweise eine aus RC-Netzwerken und einem Verstärker in bekannter Weise aufgebaute Filterschaltung 10 verwendet, deren Eingang mit dem Ausgang des Rechteck-Impulsformers 8, hier dem elektronischen Umschalter 9, verbunden ist.

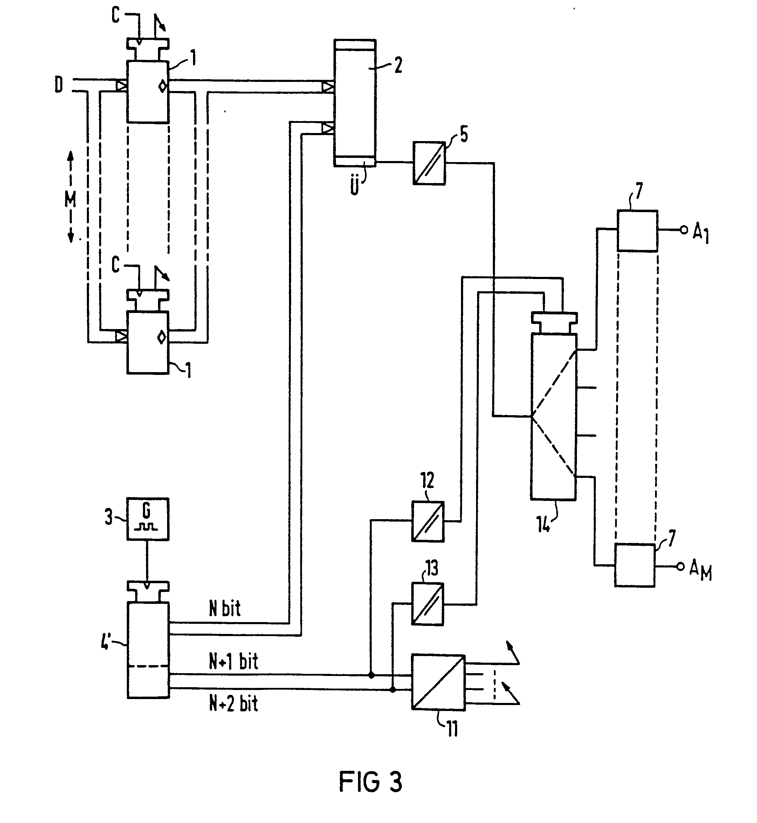

In Figur 3 ist eine Mehrkanal-Ausführung dargestellt, die nach dem gleichen Prinzip arbeitet wie die in Figur 1 gezeigte Einkanal-Ausführung Gleiche Teile sind mit gleichen Bezugszeichen gekennzeichnet.

Es sind M Datenkanäle D vorgesehen, wobei M beispielsweise 2, 3 oder 4 ist. Sie münden in M Zwischenspeicher 1 mit parallelen Speicherplätzen für N bit. Die Zwischenspeicher weisen einen Tri Staten oder OC-Ausgang auf. Die Eingangsfreigabe der einzelnen Zwischenspeicher 1 erfolgt wieder über deren Steuereingänge C.

Ein an die 11 Zwischenspeicher angeschlossener Volladdierer 2 für N bit mit Übertragsausgang Ü wird, wie bei dem vorhergehenden Beispiel, von einem mittels des frei laufenden Taktgenerators 3 angesteuerten Zähler 4' beaufschlagt.

Der Zähler 4' mit N + 1 bzw. N + 2 bit ist mit seinen Ausgängen für das N + 1. bit bei zwei Kanälen bzw. N + 1. und N + 2. bit bei drei oder vier Kanälen an einen Decoder 11 angeschlossen, mit 11 Ausgängen zum Anwählen der entsprechenden Zwischenspeicher 1. Der Decoder 11 wird mit einer Frequenz von beispielsweise $2^N \cdot 100$ Hz betrieben.

An die N + 1. bzw. N + 2. Ausgänge des Zählers 4' sind parallel zu dem Decoder 11 ein bzw. zwei Optokoppler 12 und 13 angeschlossen, deren Ausgänge mit den Steuereingängen eines Analog-Multiplexers 14 verbunden sind. Der Nutzsignaleingang des Analog-Multiplexers 14 ist an den Optokoppler 5 angeschlossen und erhält von dort die Impulsfolge aus dem Volladdierer 2, deren Puls/Pausen-Verhältnis dem Digitalwert im angewählten Zwischenspeicher 1 entspricht.

Die M Ausgänge des Analog-Multiplexers 14 führen zu einer entsprechenden Anzahl Mittelwertbildner 7, an deren Ausgängen die Analogwerte $A_1 \dots A_M$ anstehen.

Falls notwendig, kann auch bei dieser Mehrkanal-Anordnung zwischen dem Optokoppler 5 und dem Analog-Multiplexer 14 ein Rechteck-Impulsformer 8 (Figur 2) eingefügt werden; die Mittelwertbildner 7 bestehen vorzugsweise aus Filterschaltungen 10, wie sie zu Figur 2 beschrieben sind. 2

1 Digital-Analog-Wandler mit Potentialtrennung mit Hilfe von optoelektronischen Kopplungselementen, bestehend aus:

a) einem an den digitalen Datenkanal (D) angeschlossenen Zwischenspeicher (1) mit parallelen Speicherplätzen für N bit,
b) einem frei laufenden Zähler (4) mit N bit,
c) einem bit-Volladdierer (2) mit Übertragsausgang (Ü), an dessen Eingang die Ausgänge von a) und b) angeschlossen sind,
d) einem Optokoppler (5) am Ausgang des Volladdierers (2),
e) einem an den Ausgang (a) des Optokopplers (5) angeschlossenen elektronischen Mittelwertbildner (7), an dessen Ausgang ein dem digitalen Eingangswert entsprechendes analoges Ausgangssignal (A) ansteht.

2. Digital-Analog-Wandler nach Anspruch 1, gekennzeichnet durch einen vom Ausgangssignal (a) des Optokopplers (5) gesteuerten Impulsformer (8), dessen Ausgang an den Mittelwertbildner (7) angeschlossen ist.

3. Digital-Analog-Wandler mit Potentialtrennung mit Hilfe von optoelektronischen Kopplungselementen, für M Datenkanäle, bestehend aus:

a) M Zwischenspeicher (1) mit Tri State- oder OC-Ausgang und parallelen Speicherplätzen für jeweils N bit,
b) einem frei laufenden Zähler (4') mit N + 1 bzw. N + 2 bit,
c) einem N bit-Volladdierer (2) mit Übertragsausgang (Ü), an dessen Eingang die Ausgänge von a) und b) geschaltet sind,
d) einem Optokoppler (5) am Datenausgang des Volladdierers (2),
e) einem bzw. zwei Optokoppler (12, 13) an den N + 1. bzw. N + 2. Ausgängen des Zählers (4').
f) einem an die N + 1. bzw. N + 2. Ausgänge des Zählers (4') angeschlossenen Decoder (11) mit M Ausgängen zum Anwählen der M Zwischenspeicher (1) gemäß a),
g) einem Analog-Multiplexer (14), an dessen Dateneingang der Ausgang des Optokopplers (5) gemäß Merkmal d) liegt, an dessen Steuereingängen der oder die Ausgänge des oder der Optokoppler (12 bzw. 12 und 13) gemäß Merkmal e) liegen,
h) M Mittelwertbildner (7), die mit den M Ausgängen des Multiplexers (14) verbunden sind.

4. Digital-Analog-Wandler nach Anspruch 3, dadurch gekennzeichnet , daß zwischen Optokoppler (5) genmäß Merkmal d) und den Dateneingang des Analog-Multiplexers (14) ein Rechteck-Impulsformer (8) geschaltet ist.

5. Digital-Analog-Wandler nach Anspruch 1 oder 3, dadurch gekennzeichnet, daß als Mittelwertbildner (7) gemäß Anspruch 1 e) oder Anspruch 3 h) ein an sich bekanntes RC-Netzwerk mit Verstärker (10) verwendet ist.

6. Digital-Analog-Wandler nach Anspruch 2 oder 4, dadurch gekennzeichnet, daß der Impulsformer (8) ein von den Ausgangsimpulsen des Optokopplers (5) gesteuerter elektronischer Umschalter (9) ist, an dessen einem Eingang eine Referenzspannung ($U_r$) und an dessen anderem Eingang die Spannung ($U_O$) liegt.

**Claims**

1. Digital-analog-converter with potential decoupling with the aid of optoelectronic coupling elements, comprising:

a) a temporary memory (1) with parallel memory locations for N bits connected to the digital data channel (D),
b) a free-running counter (4) with N bits,
c) an N bit full adder (2) with transmission output (Ü), at whose input the outputs of a) and b) are connected,

d) an optocoupler (5) at the output of the full adder (2),

e) an electronic mean value generator (7) connected to the output (a) of the optocoupler (5), wherein there is an analog output signal (A) corresponding to the digital input value at the output of said mean value generator (7).

2. Digital-analog-converter according to Claim 1, characterised by a pulse shaper (8) controlled by the output signal (a) of the optocoupler (5), wherein the output of said pulse shaper (8) is connected to the mean value generator (7).

3. Digital-analog-converter with potential decoupling with the aid of optoelectronic coupling elements, comprising:

a) M temporary memories (1) with Tri state- or OC-output and parallel memory locations for respective N bits,

b) a free-running counter (4') with N + 1 or N + 2 bits,

c) an N bit-full adder (2) with transmission output (Ü), at whose input the outputs of a) and b) are connected,

d) an optocoupler (5) at the data output of the full adder (2),

e) one or two optocouplers (12, 13) at the N + 1. or N + 2. outputs of the counter (4'),

f) a decoder (11) with bi outputs for selecting the M temporary memories (1) according to a), which decoder (11) is connected to the N + 1. or N + 2. outputs of the counter (4'),

g) an analog-multiplexer (14), at whose data input lies the output of the optocoupler (5) according to feature d), at whose control inputs lie the output or outputs of the optocoupler or optocouplers (12 or 12 and 13) according to feature e),

h) M mean value generators (7) which are connected with the bi outputs of the multiplexer (14).

4. Digital-analog-converter according to Claim 3, characterised in that a square-wave pulse shaper (8) is connected between optocoupler (5) according to feature d) and the data input of the analog-multiplexer (14).

5. Digital-analog-converter according to Claims 1 or 3, characterized in that a known RC-network with amplifier (10) is used as the mean value generator (7) according to Claim 1 e) or Claim 3 h).

6. Digital-analog-converter according to Claims 2 or 4, characterized in that the pulse shaper (8) is an electronic change over switch (9) controlled by the output pulses of the optocoupler (5), wherein at the one input of said change over switch (9) there is a reference voltage ($U_r$) and at the other input there is the voltage ($U_O$).

## Revendications

1. Convertisseur numérique/analogique à découplage de potentiel, réalisé à l'aide d'éléments optoélectroniques de couplage, constitué par:

a) une mémoire intermédiaire (1) raccordée au canal numérique (D) de transmission de données et comportant des places de mémoire parallèles pour N bits,

b) un compteur (4) effectuant un comptage libre à N bits,

c) un additionneur complet à N bits (2), qui comporte une sortie de report (Ü) et à l'entrée duquel sont raccordées les sorties de a) et b),

d) un optocoupleur (5) raccordé à la sortie de l'additionneur complet (2),

e) un dispositif électronique (7) de formation de la valeur moyenne, qui est raccordé à la sortie (a) de l'optocoupleur (5) et dont la sortie délivre un signal de sortie analogique (A) correspondant à la valeur d'entrée numérique.

2. Convertisseur numérique/analogique suivant la revendication 1, caractérisé par un dispositif (8) de mise en forme d'impulsions, qui est commandé par le signal de sortie (a) de l'optocoupleur (5) et dont la sortie est raccordée au dispositif (7) de formation de la valeur moyenne.

3. Convertisseur numérique/analogique à découplage de potentiel, réalisé à l'aide d'éléments de couplage optoélectroniques pour M canaux de données, constitué par:

a) M mémoires intermédiaires (1) possédant une sortie trois-états ou OC et des places de mémoire parallèles pour respectivement N bits,

b) un compteur (4') réalisant un comptage libre à N + 1 ou N + 2 bits,

c) un additionneur complet à N bits (2), qui comporte une sortie de report et à l'entrée duquel sont raccordées les sorties de a) et b),

d) un optocoupleur (5) raccordé à la sortie de données de l'additionneur complet (2),

e) un ou deux optocoupleurs (12, 13) raccordés aux sorties N + 1 ou N + 2 du compteur (4'),

f) un décodeur (11) raccordé aux sorties N + 1 ou N + 2 du compteur (4') et comportant M sorties servant a sélectionner les M mémoires intermédiaires (1) conformément à a),

g) un multiplexeur analogique (14), à l'entrée de données duquel est raccordee la sortie de l'optocoupleur (5) selon la caractéristique d) et aux entrées de commande duquel sont raccordées la ou les sorties du ou des optocoupleurs (12 ou 12 et 13) conformes à la caractéristique e),

h) M dispositifs (7) de formation de valeurs moyennes, qui sont reliés aux M sorties du multiplexeur (14).

4. Convertisseur numérique/analogique suivant la revendication 3, caractérisé par le fait qu'un dispositif (8) de mise en forme d'impulsions rectangulaires est branché entre l'optocoupleur (5) conforme à la caractéristique d) et l'entrée de données du multiplexeur analogique (14).

5. Convertisseur numérique/analogique suivant la revendication 1 ou 3, caractérisé par le fait qu'on utilise, comme dispositif (7) de formation d'une valeur moyenne conformément à la caractéristique 1e) ou à la caractéristique 3h), un réseau RC connu en soi comportant un amplificateur (10).

6. Convertisseur numérique/analogique suivant la revendication 2 ou 4, caractérisé par le fait que le dispositif (8) de mise en forme d'impulsions est un commutateur électronique (9), qui est commandé par les impulsions de sortie de l'optocoupleur (5) et à une entrée duquel est appliquée une tension de référence ($U_r$) et à l'autre entrée duquel est appliquée la tension ($U_O$).

FIG 1

FIG 2

FIG 3